# EUROPÄISCHE PATENTANMELDUNG

(11) **EP 2 566 310 A1**
(43) Veröffentlichungstag der Anmeldung: **06.03.2013**
(21) Anmeldenummer: 12006172.6
(22) Anmeldetag: 30.08.2012
(51) Int. Cl.: H05K 1/14

(54) **Leiterplattensystem**

(30) Priorität: 30.08.2011 DE 102011111488
(71) Anmelder: Schoeller-Electronics GmbH, 35083 Wetter / Hessen (DE)
(72) Erfinder: Wille, Markus, 59199 Bönen (DE)
(74) Vertreter: Gottschald, Jan

(57) **Zusammenfassung**

Die Erfindung betrifft ein Leiterplattensystem mit einer zumindest abschnittsweise im Wesentlichen ebenen Trägerleiterplatte (1), wobei die Trägerleiterplatte (1) mindestens eine ein- oder beidseitig kupferkaschierte oder mit Leiterbahnen versehene starre Lage aufweist, wobei mindestens ein im Wesentlichen ebenes, parallel zu der Trägerleiterplatte (1) ausgerichtetes Leiterplattenmodul (2) mit mindestens einer ein- oder beidseitig kupferkaschierten oder mit Leiterbahnen versehenen starren Lage in einer zugeordneten Aussparung (3) in der Trägerleiterplatte (1) angeordnet ist. Es wird vorgeschlagen, dass das Leiterplattenmodul (2) in die Aussparung (3) in der Trägerleiterplatte (1) eingepresst ist und dass der Rand (4) des Leiterplattenmoduls (2) zur Bildung eines Preßsitzes kraftschlüssig mit dem Rand (5) der zugeordneten Aussparung (3) in Eingriff steht.

## Beschreibung

Die Erfindung betrifft ein Leiterplattensystem mit einer zumindest abschnittsweise im Wesentlichen ebenen Trägerleiterplatte gemäß dem Oberbegriff von Anspruch 1 sowie ein Verfahren zur Montage eines solchen Leiterplattensystems gemäß dem Oberbegriff von Anspruch 14.

Eine Leiterplatte besteht heute regelmäßig aus mehreren starren Lagen von glasfaserverstärkten, ausgehärteten Epoxidharz-Platten, die ein- oder beidseitig kupferkaschiert oder mit Leiterbahnen versehen sind. Die Leiterplatte ist bestückt mit Halbleiter-Bauteilen, mit Anschlusselementen, mit Elementen zur Wärmeableitung o. dgl..

Im Sinne eines modularen Aufbaus ist es bekannt geworden, ein Leiterplattensystem mit einer ebenen Trägerleiterplatte vorzusehen, in der mindestens ein Leiterplattenmodul angeordnet ist (DE 10 2004 019 431 A1). Dabei ist das mindestens eine, parallel zu der Trägerplatte ausgerichtete, Leiterplattenmodul in einer Aussparung in der Trägerleiterplatte angeordnet.

Problematisch bei dem obigen Leiterplattensystem ist stets die Fixierung des Leiterplattenmoduls in der zugeordneten Aussparung. Bekannte Maßnahmen für die Fixierung sind hier das Kleben, Löten o. dgl.. Diese Maßnahmen sind aufwendig in der Realisierung.

Der Erfindung liegt das Problem zugrunde, das bekannte Leiterplattensystem derart auszugestalten und weiterzubilden, dass die Fixierung des Leiterplattenmoduls in der dem Leiterplattenmodul zugeordneten Aussparung vereinfacht wird.

Das obige Problem wird bei einem Leiterplattenmodul gemäß dem Oberbegriff von Anspruch 1 durch die Merkmale des kennzeichnenden Teils von Anspruch 1 gelöst.

Wesentlich ist die Überlegung, dass die mechanische Stabilität von Trägerleiterplatte und Leiterplattenmodul regelmäßig ausreicht, um einen Presssitz für das Leiterplattenmodul zu realisieren.

Entsprechend wird vorgeschlagen, dass das Leiterplattenmodul in die dem Leiterplattenmodul zugeordnete Aussparung in der Trägerleiterplatte eingepresst ist und dass der Rand des Leiterplattenmoduls zur Bildung eines Presssitzes kraftschlüssig mit dem Rand der zugeordneten Aussparung in Eingriff steht.

Wesentlich für die vorschlagsgemäße Lehre ist die Tatsache, dass die Anordnung konstruktiv so getroffen ist, dass ein Einpressen des Leiterplattenmoduls mit einer Einpreßkraft, die im Wesentlichen senkrecht zu der Flachseite des Leiterplattenmoduls ausgerichtet ist, möglich ist.

Bei geeigneter Auslegung ist der Presssitz des Leiterplattenmoduls hinreichend für die dessen Fixierung in der Trägerleiterplatte (Anspruch 3). Mit weniger Aufwand lässt sich die Fixierung des Leiterplattenmoduls nicht realisieren.

Interessant bei der vorschlagsgemäßen Lösung ist die Tatsache, dass das Leiterplattenmodul in beliebiger Hinsicht unterschiedlich zu dem Leiterplattenträger ausgestaltet sein kann. Hierdurch lassen sich erhebliche Kosten bei der Herstellung des Leiterplattensystems erzielen, beispielsweise indem kostenintensive Materialien nur dort eingesetzt werden, wo sie unbedingt benötigt werden.

Bei der besonders bevorzugten Ausgestaltung gemäß Anspruch 13 lässt sich das Leiterplattenmodul aus der Aussparung entfernen und anschließend wieder einsetzen. Dies kann eventuelle Wartungsarbeiten vereinfachen.

Nach einer weiteren Lehre gemäß Anspruch 14, der ebenfalls eigenständige Bedeutung zukommt, wird ein Verfahren zur Montage eines vorschlagsgemäßen Leiterplattensystems beansprucht.

Wesentlich nach der weiteren Lehre ist, dass das Leiterplattenmodul in die Aussparung in der Trägerleiterplatte eingepresst wird und dass dabei der Rand des Leiterplattenmoduls zur Bildung eines Presssitzes kraftschlüssig mit dem Rand der zugeordneten Aussparung in Eingriff gebracht wird.

Besonders vorteilhaft bei dem vorschlagsgemäßen Verfahren ist die Tatsache, dass der Verfahrensschritt des Einbringens des Leiterplattenmoduls in die Aussparung in der Trägerleiterplatte ganz besonders einfach realisierbar ist.

Bei der besonders bevorzugten Ausgestaltung gemäß Anspruch 15 wird das Leiterplattenmodul in die Aussparung der Trägerleiterplatte eingeklipst, so dass die Einpresskraft beim Einbringen des Leiterplattenmoduls ein steiles Maximum durchläuft. Vorteilhaft ist hierbei u.a. die Tatsache, dass durch das Einklipsen eine vordefinierte und reproduzierbare Einpresstiefe eingehalten wird.

Im Folgenden wird die Erfindung anhand einer lediglich Ausführungsbeispiele darstellenden Zeichnung näher erläutert. In der Zeichnung zeigt:
- Fig. 1: ein vorschlagsgemäßes Leiterplattensystem a) bei demontiertem Leiterplattenmodul und b) bei montiertem Leiterplattenmodul, jeweils in einer perspektivischen Darstellung,
- Fig. 2: a) ein weiteres vorschlagsgemäßes Leiterplattensystem bei demontiertem Leiterplattenmodul in einer perspektivischen Darstellung ein, b) ein weiteres vorschlagsgemäßes Leiterplattensystem bei demontiertem Leiterplattenmodul in einer Schnittdarstellung, c) ein weiteres vorschlagsgemäßes Leiterplattensystem bei demontiertem Leiterplattenmodul in einer Schnittdarstellung,
- Fig. 3: ein weiteres vorschlagsgemäßes Leiterplattensystem bei demontiertem Leiterplattenmodul in einer perspektivischen Darstellung.

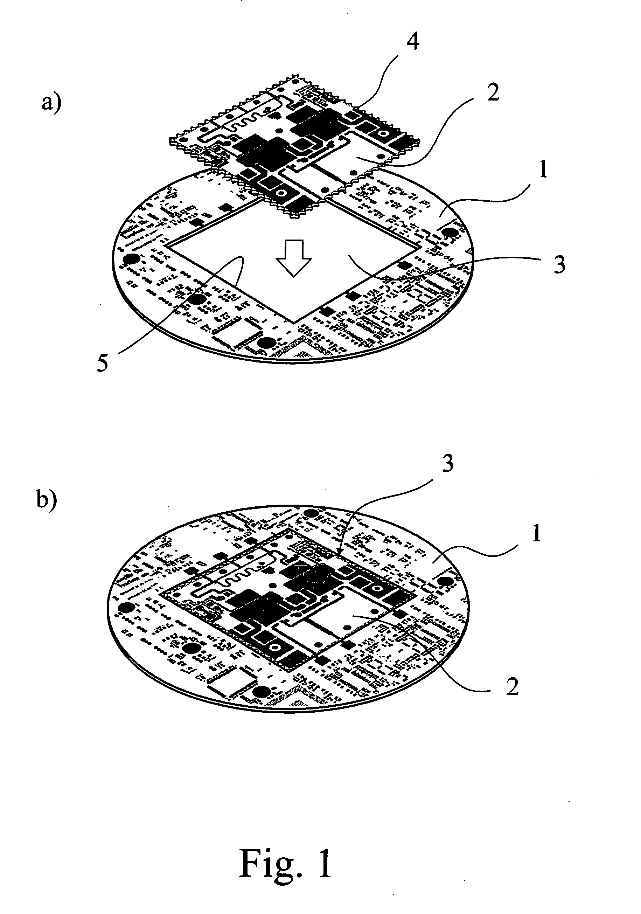

Das in Fig. 1 dargestellte Leiterplattensystem ist mit einer im Wesentlichen ebenen Trägerleiterplatte 1 und einem im Wesentlichen ebenen Leiterplattenmodul 2 ausgestattet, das im montierten Zustand gemäß Fig. 1b) in eine zugeordnete, Aussparung 3 in der Trägerleiterplatte 1 eingebracht ist.

Die Formulierung "im Wesentlichen eben" bedeutet vorliegend, dass die Trägerleiterplatte 1 und das Leiterplattenmodul 2 nicht eben im idealen Sinne sein müssen. Gemeint ist vielmehr, dass sich die Trägerleiterplatte 1 und das Leiterplattenmodul 2 jeweils entlang einer Ebene erstrecken. Grundsätzlich kann es auch vorgesehen sein, dass die Trägerleiterplatte 1 und das Leiterplattenmodul 2 nur abschnittsweise im Wesentlichen eben ausgestaltet sind.

Sowohl die Trägerleiterplatte 1 als auch das Leiterplattenmodul 2 sind jeweils mit mindestens einer ein- oder beidseitig kupferkaschierten oder mit Leiterbahnen versehenen starren Lage ausgestattet. Diese mindestens eine Lage besteht vorzugsweise aus einer glasfaserverstärkten, ausgehärteten Epoxidharz-Platte, aus Keramik o. dgl..

Im montierten Zustand ist das Leiterplattenmodul 2 parallel zu der Trägerleiterplatte 1 ausgerichtet, wie der Darstellung gemäß Fig. 1b) zu entnehmen ist.

Es darf darauf hingewiesen werden, dass die Trägerleiterplatte 1 eine beliebige Anzahl von Leiterplattenmodulen 2 aufnehmen kann, wobei jedem Leiterplattenmodul 2 eine entsprechende Aussparung 3 in der Trägerleiterplatte 1 zugeordnet ist. Im Folgenden ist im Sinne einer übersichtlichen Darstellung stets von einem einzigen Leiterplattenmodul 2 und einer einzigen dem Leiterplattenmodul 2 zugeordneten Aussparung 3 die Rede. Alle Ausführungen zu diesem Leiterplattenmodul 2 gelten für alle ggf. vorgesehenen, weiteren Leiterplattenmodule entsprechend.

Wesentlich ist, dass das Leiterplattenmodul 2 in die Aussparung 3 in der Trägerleiterplatte 1 eingepresst ist und dass der Rand 4 des Leiterplattenmoduls 2 zur Bildung eines Presssitzes kraftschlüssig mit dem Rand 5 der zugeordneten Aussparung 3 in Eingriff steht.

Das Einpressen des Leiterplattenmoduls 2 in die Aussparung 3 in der Trägerleiterplatte 1 erfolgt zu einem zweckmäßigen Zeitpunkt innerhalb des Produktionsprozesses. Denkbar ist, dass das Einpressen am Ende des Herstellungsprozesses erfolgt, wenn die Trägerleiterplatte 1 und das Leiterplattenmodul 2 jeweils für sich genommen fertiggestellt sind. Es ist aber auch möglich, dass die Trägerleiterplatte 1 und das Leiterplattenmodul 2 in einem Produktionszwischenschritt zusammengefügt werden. Dann durchlaufen die Trägerleiterplatte 1 und das Leiterplattenmodul 2 weitere Prozessstufen gemeinsam. Bei diesen Prozessstufen kann es sich um Lötstufen, Metallisierungsstufen o. dgl. handeln.

Bei der Aussparung 3 handelt es sich hier und vorzugsweise, wie in Fig. 1a) dargestellt, um eine durchgehende Aussparung, also um eine Öffnung innerhalb der Trägerleiterplatte 1. Das montierte Leiterplattenmodul 2 ist entsprechend von beiden Seiten der Trägerleiterplatte 1 zugänglich.

Von besonderer Bedeutung ist vorliegend die Tatsache, dass der den Presssitz bewirkende Kraftschluss im Wesentlichen parallel zu der Ebene der Trägerleiterplatte 1 ausgerichtet ist. Die Fixierung des Leiterplattenmoduls 2 geht dabei teilweise auf eine plastische Verformung der Trägerleiterplatte 1 und des Leiterplattenmoduls 2, teilweise auf einen Formschluss zwischen Trägerleiterplatte 1 und Leiterplattenmodul 2 und teilweise auf Reibung zwischen Trägerleiterplatte 1 und Leiterplattenmodul 2 zurück.

In besonders bevorzugter Ausgestaltung ist die Anordnung so getroffen, dass die Fixierung im Wesentlichen ausschließlich auf den Presssitz des Leiterplattenmoduls 2 zurückgeht.

Bei der in Fig. 1b) dargestellten und insoweit bevorzugten Ausgestaltung steht das Leiterplattenmodul 2 vollständig formschlüssig mit der zugeordneten Aussparung 3 in Eingriff. Denkbar ist aber auch, dass dieser Formschluss sich nur über einen Abschnitt des Leiterplattenmoduls 2 erstreckt.

Es lässt sich der Darstellung gemäß Fig. 1b) auch entnehmen, dass das Leiterplattenmodul 2 und die Trägerleiterplatte 1 im Wesentlichen in einer Ebene angeordnet sind, wobei vorzugsweise das Leiterplattenmodul 2 und die Trägerleiterplatte 1 bündig abschließen. Hier und vorzugsweise ist es sogar so, dass das Leiterplattenmodul 2 und die Trägerleiterplatte 1 beidseitig bündig abschließen. Damit ist es ohne weiteres möglich, dass eine Lötstufe, wie oben angesprochen, bei montiertem Leiterplattenmodul 2 durchlaufen wird.

Das Leiterplattenmodul 2 muss aber nicht beidseitig mit der Trägerleiterplatte 1 bündig abschließen. Das Leiterplattenmodul 2 kann beispielsweise zu mindestens einer Außenseite in einem definierten Maße hervorstehen, so dass bei entsprechenden konstruktiven Randbedingungen ein einfacher Zugang zu einem Gehäuse o. dgl. ermöglicht werden kann.

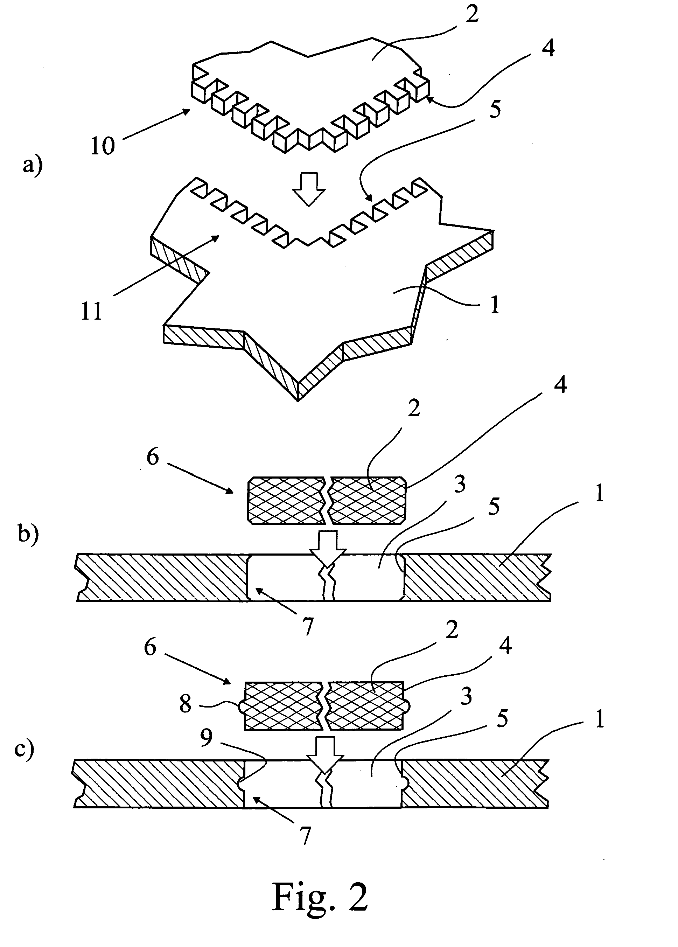

Die Darstellungen gemäß Fig. 2b) und c) zeigen, dass das Querschnittsprofil 6 des Randes 4 des Leiterplattenmoduls 2 und das Querschnittsprofil 7 des Randes 5 der zugeordneten Aussparung 3 zur Bildung eines Formschlusses aufeinander abgestimmt sind. Dabei ist es in beiden Fällen so, dass jeweils ein konvexer Querschnitt 6 einem konkaven Querschnitt 7 zur Bildung des Formschlusses zugeordnet ist.

Im Einzelnen ist es so, dass das Querschnittsprofil 6 des Randes 4 des Leiterplattenmoduls 2 einen umlaufenden Steg 8 bildet, während das Querschnittsprofil 7 des Randes 5 der zugeordneten Aussparung 3 eine umlaufende Nut 9 bildet. Grundsätzlich kann die Zuordnung von Steg 8 und Nut 9 auch umgekehrt vorgesehen sein. Wesentlich ist dabei die Tatsache, dass mit dem Eingriff von Steg 8 und Nut 9 ein Einklipsen des Leiterplattenmoduls 2 in die Trägerleiterplatte 1 möglich ist, wie noch erläutert wird.

Interessant bei dem in Fig. 2a) dargestellten Ausführungsbeispiel ist die Tatsache, dass die Außenkontur 10 des Randes 4 des Leiterplattenmoduls 2 und die Innenkontur 11 des Randes 5 der zugeordneten Aussparung 3 zur Bildung eines Formschlusses aufeinander abgestimmt sind. Hier und vorzugsweise ist es so, dass die beiden Ränder 4 und 5 ineinander verzahnt sind.

Ganz allgemein weisen die Außenkontur 10 des Randes 4 des Leiterplattenmoduls 2 und/oder die Innenkontur 11 des Randes 5 der zugeordneten Aussparung 3 vorzugsweise eine periodisch sich wiederholende Struktur, insbesondere eine gezahnte, gezackte oder gewellte Struktur auf. Grundsätzlich ist hier auch ein Formschluss nach Art einer Schwalbenschwanz-Verbindung o. dgl. denkbar.

Um eine hinreichende, randseitige Stabilität für den Presssitz des Leiterplattenmoduls 2 zu gewährleisten ist es weiter vorzugsweise vorgesehen, dass der Rand 4 des Leiterplattenmoduls 2 und/oder der Rand 5 der Aussparung 3 zumindest zum Teil metallisiert ist bzw. sind. Grundsätzlich sind hier auch andere Oberflächenbehandlungen denkbar, die u.a. zu einer Härtung der randseitigen Oberflächen führen.

Es wurde schon darauf hingewiesen, dass das Leiterplattensystem gemäß der vorschlagsgemäßen Lösung abschnittsweise auf die jeweiligen funktionalen Randbedingungen hin ausgelegt werden kann. Dies lässt sich dadurch realisieren, dass das Leiterplattenmodul 2 im Hinblick auf Materialzusammensetzung und/oder Oberflächenbeschaffenheit und/oder Lagenaufbau und/oder Lagenanzahl und/oder Plattendicke unterschiedlich zu der Trägerleiterplatte 1 ausgestaltet sein kann. Grundsätzlich lassen sich damit günstigere Material- und Produktionskosten erzielen, insbesondere, wenn bestimmte Funktionen und Aufgaben auf die jeweiligen Leiterplattenmodule 2 verteilt werden.

Ferner können die Trägerleiterplatte 1 und das Leiterplattenmodul 2 separat voneinander in optimierter Weise vorproduziert und dann zu dem oben angesprochenen Zeitpunkt zusammengefügt werden.

Die Trägerleiterplatte 1 und das Leiterplattenmodul 2 können völlig unterschiedliche Funktionen ausführen. Beispielsweise kann es vorgesehen sein, dass das Leiterplattenmodul 2 hochfrequenztechnische Funktionen, beispielsweise die Funktion eines Hochfrequenz-Verstärkers, ausführt, während die Trägerleiterplatte 1 im Wesentlichen als Logik-Leiterplatte ausgerührt ist. Hier wird deutlich, dass durch eine geeignete Auswahl von Leiterplattenmodulen 2 eine funktionale Modularisierung des Leiterplattensystems möglich ist, die zu einer optimalen Variantenbildung und zu einer erheblichen Kostenreduzierung beitragen kann.

Es ist auch denkbar, dass die Trägerleiterplatte 1 und/oder das Leiterplattenmodul 2 als starrflexible Leiterplatte ausgestaltet ist bzw. sind. Dann ist es vorzugsweise so, dass sich ein flexibler Abschnitt des Leiterplattenmoduls 2 über den Rand 5 der zugeordneten Aussparung 3 in der Trägerleiterplatte 1 erstreckt. Der flexible Abschnitt des Leiterplattenmoduls 2 kann so als elektrischer Anschluss des Leiterplattenmoduls 2 an die Trägerleiterplatte 1 genutzt werden.

In besonders bevorzugter Ausgestaltung ist es vorgesehen, dass die elektrische Kontaktierung zwischen der Trägerleiterplatte 1 und dem Leiterplattenmodul 2 durch das Einsetzen des Leiterplattenmoduls 2 in die zugeordnete Aussparung 3 hergestellt wird. Denkbar ist beispielsweise, dass entsprechende elektrische Kontakte über den Rand 5 der Aussparung 3 hinausstehen, in deren Kontakt das Leiterplattenmodul 2 bei dessen Einpressen kommt. Andere vorteilhaften Varianten für die elektrische Kontaktierung des Leiterplattenmoduls 2 sind denkbar.

Grundsätzlich lässt sich der für den Presssitz des Leiterplattenmoduls 2 erforderliche Kraftschluss durch die geometrische Auslegung der Ränder 4, 5 von Leiterplattenmodul 2 und Aussparung 3 einstellen. Für eine weitergehende Einstellung des Kraftschlusses ist es vorzugsweise vorgesehen, dass die Trägerleiterplatte 1 im Bereich der Aussparung 3 mindestens einen elastischen Bereich 12 aufweist, dessen elastische Rückstellkraft auf das Leiterplattenmodul 2 wirkt.

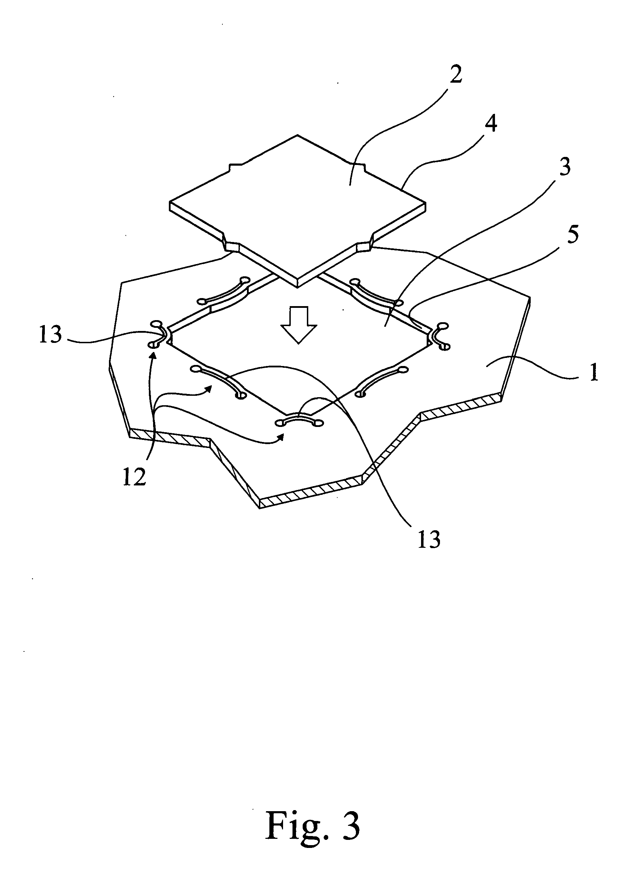

Bei der in Fig. 3 dargestellten und insoweit bevorzugten Ausführungsbeispiel weist der mindestens eine elastische Bereich 12 zur Erhöhung der elastischen Nachgiebigkeit eine Materialschwächung 13 auf, die hier und vorzugsweise als schlitzartige Ausnehmung realisiert ist. Denkbar ist aber auch, dass die Materialschwächung 13 eine Durchkontaktierung in der Trägerleiterplatte 1 aufweist. Es hat sich in Versuchen gezeigt, dass sich die elastische Nachgiebigkeit insbesondere durch die gezielte Einbringung von Durchkontaktierungen im gewünschten elastischen Bereich 12 relativ genau einstellen lässt.

Es wurde weiter oben schon darauf hingewiesen, dass in besonders bevorzugter Ausgestaltung die Fixierung des Leiterplattenmoduls 2 ausschließlich auf den Presssitz des Leiterplattenmoduls 2 zurückgeht. Hier und vorzugsweise ist es so, dass das Leiterplattenmodul 2 durch Aufbringung einer Ausrückkraft aus der Aussparung 3 entfernbar und anschließend wieder unter Bildung des Presssitzes in die Aussparung 3 einpressbar ist. Damit lassen sich Wartungsarbeiten auf besonders einfache Weise durchführen, indem das betreffende Leiterplattenmodul 2 zur Wartung herausgenommen wird. Im Reparaturfall kann das betreffende Leiterplattenmodul 2 leicht ausgetauscht werden, was die Reparaturkosten ganz erheblich reduzieren kann. Der Vollständigkeit halber darf aber darauf hingewiesen werden, dass zusätzlich zu dem Presssitz herkömmliche Fixiermethoden angewandt werden können. Dazu gehören Kleben, Löten und Metallisieren des Randbereichs zwischen Leiterplattenmodul 2 und Trägerleiterplatte 1.

Die vorschlagsgemäße Lösung ist auch im Hinblick auf die Befestigung des Leiterplattensystems vorteilhaft. Denkbar ist hier, dass sowohl die Trägerleiterplatte 1 als auch das Leiterplattenmodul 2 Öffnungen enthalten können, die der Befestigung des Leiterplattensystems dienen. Weiter können die Trägerleiterplatte 1 und das Leiterplattenmodul 2 Öffnungen enthalten, die zu Montagezwecken von Bauelementen oder Flachbaugruppen genutzt werden können.

Denkbar ist ferner, dass die Trägerleiterplatte 1 und das Leiterplattenmodul 2 Kavitäten aufweisen, die zur Aufnahme von Bauelementen, insbesondere zur Aufnahme von Nacktchips, dienen können.

Schließlich darf darauf hingewiesen werden, dass die Trägerleiterplatte 1 und das Leiterplattenmodul 2 integrierte Elemente zur Wärmeableitung, insbesondere Wärmesenken, enthalten können.

Nach einer weiteren Lehre, der ebenfalls eigenständige Bedeutung zukommt, wird ein Verfahren zur Montage des vorschlagsgemäßen Leiterplattensystems beansprucht. Wesentlich ist, dass das Leiterplattenmodul 2 in die Aussparung 3 in der Trägerleiterplatte 1 eingepresst wird und dass dabei der Rand 4 des Leiterplattenmoduls 2 zur Bildung eines Presssitzes kraftschlüssig mit dem Rand 5 der zugeordneten Aussparung 3 in Eingriff gebracht wird. Insoweit darf auf alle obigen Ausführungen zu dem vorschlagsgemäßen Leiterplattensystems verwiesen werden.

In besonders bevorzugter Ausgestaltung wird das Leiterplattenmodul 2 in die Aussparung 3 in der Trägerleiterplatte 1 eingeklipst. Es wurde schon darauf hingewiesen, dass damit eine genaue Einpresstiefe des Leiterplattenmoduls 2 in der Trägerleiterplatte 1 gewährleistet werden kann. Dies lässt sich durch den ebenfalls oben beschriebenen Formschluss im Querschnitt zwischen Leiterplattenmodul 2 und Trägerleiterplatte 1 realisieren.

## Patentansprüche

1. Leiterplattensystem mit einer zumindest abschnittsweise im Wesentlichen ebenen Trägerleiterplatte (1), wobei die Trägerleiterplatte (1) mindestens eine ein- oder beidseitig kupferkaschierte oder mit Leiterbahnen versehene starre Lage aufweist, wobei mindestens ein im Wesentlichen ebenes, parallel zu der Trägerleiterplatte (1) ausgerichtetes Leiterplattenmodul (2) mit mindestens einer ein- oder beidseitig kupferkaschierten oder mit Leiterbahnen versehenen starren Lage in einer zugeordneten Aussparung (3) in der Trägerleiterplatte (1) angeordnet ist,
**dadurch gekennzeichnet,**
**dass** das Leiterplattenmodul (2) in die Aussparung (3) in der Trägerleiterplatte (1) eingepresst ist und dass der Rand (4) des Leiterplattenmoduls (2) zur Bildung eines Preßsitzes kraftschlüssig mit dem Rand (5) der zugeordneten Aussparung (3) in Eingriff steht.

2. Leiterplattensystem nach Anspruch 1, **dadurch gekennzeichnet, dass** der Kraftschluß im Wesentlichen parallel zu der Ebene der Trägerleiterplatte (1) ausgerichtet ist.

3. Leiterplattensystem nach Anspruch 1 oder 2, **dadurch gekennzeichnet, dass** im Wesentlichen ausschließlich der Preßsitz das Leiterplattenmodul (2) in der Aussparung (3) in der Trägerleiterplatte (1) hält.

4. Leiterplattensystem nach einem der vorhergehenden Ansprüche, **dadurch gekennzeichnet, dass** das Leiterplattenmodul (2) zumindest abschnittsweise, vorzugsweise vollständig, formschlüssig mit der zugeordneten Aussparung (3) in Eingriff steht, und/oder, dass das Leiterplattenmodul (2) und die Trägerleiterplatte (1) im Wesentlichen in einer Ebene angeordnet sind, vorzugsweise, dass das Leiterplattenmodul (2) und die Trägerleiterplatte (1), insbesondere beidseitig, bündig abschließen.

5. Leiterplattensystem nach einem der vorhergehenden Ansprüche, **dadurch gekennzeichnet, dass** das Querschnittsprofil (6) des Randes (4) des Leiterplattenmoduls (2) und das Querschnittsprofil (7) des Randes (5) der zugeordneten Aussparung (3) zur Bildung eines Formschlusses aufeinander abgestimmt sind.

6. Leiterplattensystem nach einem der vorhergehenden Ansprüche, **dadurch gekennzeichnet, dass** das Querschnittsprofil (6) des Randes (4) des Leiterplattenmoduls (2) und/oder das Querschnittsprofil (7) des Randes (5) der zugeordneten Aussparung (3) mindestens einen umlaufenden Steg (8) und/oder mindestens eine umlaufende Nut (9) bildet bzw. bilden.

7. Leiterplattensystem nach einem der vorhergehenden Ansprüche, **dadurch gekennzeichnet, dass** die Außenkontur (10) des Randes (4) des Leiterplattenmoduls (2) und/oder die Innenkontur (11) des Randes (5) der zugeordneten Aussparung (3) eine periodisch sich wiederholende Struktur, insbesondere eine gezahnte, gezackte oder gewellte Struktur, aufweist bzw. aufweisen.

8. Leiterplattensystem nach einem der vorhergehenden Ansprüche, **dadurch gekennzeichnet, dass** der Rand (4) des Leiterplattenmoduls (2) und/oder der Rand (5) der Aussparung (3) zumindest zum Teil metallisiert ist bzw. sind.

9. Leiterplattensystem nach einem der vorhergehenden Ansprüche, **dadurch gekennzeichnet, dass** das Leiterplattenmodul (2) im Hinblick auf Materialzusammensetzung und/oder Oberflächenbeschaffenheit und/oder Lagenaufbau und/oder Lagenanzahl und/oder Plattendicke unterschiedlich zu der Trägerleiterplatte (1) ausgestaltet ist.

10. Leiterplattensystem nach einem der vorhergehenden Ansprüche, **dadurch gekennzeichnet, dass** die Trägerleiterplatte (1) und/oder das Leiterplattenmodul (2) als starrflexible Leiterplatte ausgestaltet ist bzw. sind, vorzugsweise, dass sich ein flexibler Abschnitt des Leiterplattenmoduls (2) über den Rand (5) der zugeordneten Aussparung (3) in der Trägerleiterplatte (1) erstreckt.

11. Leiterplattensystem nach einem der vorhergehenden Ansprüche, **dadurch gekennzeichnet, dass** eine elektrische Kontaktierung zwischen der Trägerleiterplatte (1) und dem Leiterplattenmodul (2) vorgesehen ist, vorzugsweise, dass die elektrische Kontaktierung durch das Einsetzen des Leiterplattenmoduls (2) in die zugeordnete Aussparung (3) hergestellt wird.

12. Leiterplattensystem nach einem der vorhergehenden Ansprüche, **dadurch gekennzeichnet, dass** die Trägerleiterplatte (1) im Bereich der Aussparung (3) mindestens einen elastischen Bereich (12) aufweist, dessen elastische Rückstellkraft auf das Leiterplattenmodul (2) wirkt, vorzugsweise, dass der mindestens eine elastische Bereich (12) zur Erhöhung der elastischen Nachgiebigkeit mindestens eine Materialschwächung (13), insbesondere mindestens eine Aussparung oder mindestens eine Durchkontaktierung, in der Trägerleiterplatte (1) aufweist.

13. Leiterplattensystem nach einem der vorhergehenden Ansprüche, **dadurch gekennzeichnet, dass** das Leiterplattenmodul (2) durch Aufbringung einer Ausrückkraft aus der Aussparung (3) entfernbar ist und anschließend wieder unter Bildung des Preßsitzes in die Aussparung (3) einpressbar ist.

14. Verfahren zur Montage eines Leiterplattensystems mit einer zumindest abschnittsweise im Wesentlichen ebenen Trägerleiterplatte (1), wobei die Trägerleiterplatte (1) mindestens eine ein- oder beidseitig kupferkaschierte oder mit Leiterbahnen versehene starre Lage aufweist, wobei mindestens ein im Wesentlichen ebenes, parallel zu der Trägerleiterplatte (1) ausgerichtetes Leiterplattenmodul (2) mit mindestens einer ein- oder beidseitig kupferkaschierten oder mit Leiterbahnen versehenen starren Lage in einer zugeordneten Aussparung (3) in der Trägerleiterplatte (1) angeordnet wird,
**dadurch gekennzeichnet,**
**dass** das Leiterplattenmodul (2) in die Aussparung (3) in der Trägerleiterplatte (1) eingepresst wird und dass dabei der Rand (4) des Leiterplattenmoduls (2) zur Bildung eines Preßsitzes kraftschlüssig mit dem Rand (5) der zugeordneten Aussparung (3) in Eingriff gebracht wird.

15. Verfahren nach Anspruch 14, **dadurch gekennzeichnet, dass** das Leiterplattenmodul (2) in die Aussparung (3) in der Trägerleiterplatte (1) eingeklipst wird.
